# EUROPEAN PATENT APPLICATION

(11) **EP 4 443 512 A1**
(43) Date of publication of application: **09.10.2024**
(21) Application number: 23167107.4
(22) Date of filing: 06.04.2023
(51) Int. Cl.: H01L 29/06, H01L 29/40, H01L 29/78, H01L 21/336

(54) **SEMICONDUCTOR DEVICE**

(71) Applicant: Infineon Technologies Austria AG, 9500 Villach (AT)
(72) Inventor: LAFORET, David, 9500 Villach (AT); SIEMIENIEC, Thomas Ralf, 9500 Villach (AT); ALTSTÄTTER, Christof, 9908 Amlach (AT); HOFER, Heimo, 9551 Steindorf (AT)
(74) Representative: JENSEN & SON

(57) **Abstract**

According to an embodiment, a transistor device is provided that comprises a semiconductor substrate having a first major surface and one or more transistor cells. Each transistor cell comprises a columnar trench formed in the semiconductor substrate, a columnar field plate arranged in the columnar trench and a mesa arranged around the columnar trench. The columnar trench comprises a field dielectric, a base and a side wall. The side wall extends from the base to the first major surface and the field dielectric lines the base and side wall of the columnar trench. A first thickness of the field dielectric at a first distance from the base is smaller than a second thickness of the field dielectric at a second distance from the base, wherein the first distance is greater than the second distance. A first perimeter of the columnar field plate at the first distance is greater than a second perimeter of the columnar field plate at the second distance.

## Description

### BACKGROUND

Transistor devices used in power electronic applications are often fabricated with silicon (Si) semiconductor materials. Common transistor devices for power applications include Si CoolMOSO, Si Power MOSFETs and Si Insulated Gate Bipolar Transistors (IGBTs).

A transistor device for power applications may be based on the charge compensation principle and may include an active cell field including a plurality of trenches, each including a field plate for charge compensation. In some designs, the trenches and the mesas that are formed between adjacent trenches each have an elongate striped structure. In some other designs, the trenches and field plates each have a columnar, needle-like shape.

Further improvements would be desirable to further improve the performance of transistor devices with columnar field plates, for example by reducing the on-state resistance RDS(on).Area.

### SUMMARY

According to an embodiment of the invention, a transistor device is provided that comprises a semiconductor substrate having a first major surface and one or more transistor cells. Each transistor cell comprises a columnar trench formed in the semiconductor substrate, a columnar field plate arranged in the columnar trench and a mesa arranged around the columnar trench. The columnar trench comprises a field dielectric, a base and a side wall. The side wall extends from the base to the first major surface and the field dielectric lines the base and side wall of the columnar trench. A first thickness of the field dielectric at a first distance from the base is smaller than a second thickness of the field dielectric at a second distance from the base, wherein the first distance is greater than the second distance. A first perimeter of the columnar field plate at the first distance is greater than a second perimeter of the columnar field plate at the second distance.

According to an embodiment of the invention, a method comprises forming a plurality of columnar trenches in a first major surface of a semiconductor substrate having a first conductivity type, the columnar trenches each having a base and a side wall extending from the base to the first major surface, forming a first dielectric layer on the base and side wall of the columnar trenches, depositing a second dielectric layer on the first dielectric layer, removing at least a part of the second dielectric layer from an upper portion of the columnar trenches and inserting conductive material into the columnar trenches to form a field plate.

Those skilled in the art will recognize additional features and advantages upon reading the following detailed description, and upon viewing the accompanying drawings.

### BRIEF DESCRIPTION

The elements of the drawings are not necessarily to scale relative to each other. Like reference numerals designate corresponding similar parts. The features of the various illustrated embodiments can be combined unless they exclude each other. Exemplary embodiments are depicted in the drawings and are detailed in the description which follows.
Figure 1, which includes figures 1A to 1C, illustrates a semiconductor device, whereby figures 1A and 1B illustrate a schematic top view of according to two embodiments and figure 1C illustrates a cross-sectional view.
Figure 2, which includes figures 2A to 2E, illustrates cross-sectional views of a columnar trench comprising a field plate according to various embodiments.
Figure 3, which includes figures 3A to 3B, illustrates a lateral arrangement of four transistor cells.
Figure 4A and 4B show an enlarged view top view of one of the columnar trenches of figure 3A.
Figure 5 which includes figures 5A to 5J illustrates a method of fabricating a columnar trench having a columnar field plate and field dielectric.
Figure 6, which includes figures 6A to 6H, illustrates a method for fabricating a ring-shaped contact to a columnar field plate located within a columnar trench.

### DETAILED DESCRIPTION

In the following detailed description, reference is made to the accompanying drawings, which form a part hereof, and in which is shown by way of illustration specific embodiments in which the invention may be practiced. In this regard, directional terminology, such as "top", "bottom", "front", "back", "leading", "trailing", etc., is used with reference to the orientation of the figure(s) being described. Because components of the embodiments can be positioned in a number of different orientations, the directional terminology is used for purposes of illustration and is in no way limiting. It is to be understood that other embodiments may be utilized and structural or logical changes may be made without departing from the scope of the present invention. The following detailed description, thereof, is not to be taken in a limiting sense, and the scope of the present invention is defined by the appended claims.

A number of exemplary embodiments will be explained below. In this case, identical structural features are identified by identical or similar reference symbols in the figures. In the context of the present description, "lateral" or "lateral direction" should be understood to mean a direction or extent that runs generally parallel to the lateral extent of a semiconductor material or semiconductor carrier. The lateral direction thus extends generally parallel to these surfaces or sides. In contrast thereto, the term "vertical" or "vertical direction" is understood to mean a direction that runs generally perpendicular to these surfaces or sides and thus to the lateral direction. The vertical direction therefore runs in the thickness direction of the semiconductor material or semiconductor carrier.

As employed in this specification, when an element such as a layer, region or substrate is referred to as being "on" or extending "onto" another element, it can be directly on or extend directly onto the other element or intervening elements may also be present. In contrast, when an element is referred to as being "directly on" or extending "directly onto" another element, there are no intervening elements present.

As employed in this specification, when an element is referred to as being "connected" or "coupled" to another element, it can be directly connected or coupled to the other element or intervening elements may be present. In contrast, when an element is referred to as being "directly connected" or "directly coupled" to another element, there are no intervening elements present.

As used herein, various device types and/or doped semiconductor regions may be identified as being of n type or p type, but this is merely for convenience of description and not intended to be limiting, and such identification may be replaced by the more general description of being of a "first conductivity type" or a "second, opposite conductivity type" where the first type may be either n or p type and the second type then is either p or n type.

The Figures illustrate relative doping concentrations by indicating "-" or "+" next to the doping type "n" or "p". For example, "n⁻" means a doping concentration which is lower than the doping concentration of an "n"-doping region while an "n⁺"-doping region has a higher doping concentration than an "n"-doping region. Doping regions of the same relative doping concentration do not necessarily have the same absolute doping concentration. For example, two different "n"-doping regions may have the same or different absolute doping concentrations.

In an embodiment, a transistor device with needle trench structures is provided that may be used for devices operating in a medium-voltage range, for example from around 60V to 200V, which enables a further reduction of the RDS(on) x Area while keeping the FOMs at least constant or improving them.

In an embodiment, a trench MOSFET is provided which comprises charge carrier compensation provided by needle-shaped (columnar) field-plate trenches and their associated needle-shaped (columnar) field plate which may be arranged in a staggered lattice pattern, and separate gate trenches. In some embodiments, the gate trenches form a gate grid that surrounds the individual ones of the needle trenches. In other embodiments, a plurality of separate gate trenches, which extend in lines over the surface of the semiconductor chip between needle-shaped trenches, is used. The lines may be straight or meander, for example zig zag, to follow the shape of needle trenches, for example needle trenches with a hexagonal shape (area). The field plate trenches each have a so-called stepped field dielectric, e.g. a field oxide, with at least one step, whereby the thickness of the field oxide decreases from the top to the bottom of the trench. A contact has a ring-shape (e.g., donut-like) and connects to both source region in the mesa and the field plate. In some embodiments, the needle-shaped field-plate trenches have a hexagonal cross-section with the gate grid following this hexagonal shape.

In a staggered layout of the needle trenches, the individual transistor cells are not arranged in an orthogonal grid, but in a mutually shifted or staggered grid. Hexagonal geometries for the lateral shape of the field plate trenches, field plates and gate grid may be used. The increase in the effective mesa width at the crossing points is small which enables higher doping in the drift zone. The staggered design also results in a lower area-specific on-resistance.

In examples the field dielectric may be a stepped field dielectric. In some examples, only two dielectric thicknesses may be realized, the difference between the two thicknesses being greater than that arising from processing variations). The field dielectric may be an oxide, for example SiOₓ, for a silicon substrate.

By having the lower field oxide thickness in an upper region of the trench and the higher field oxide thickness only in a lower region of the trench, high mechanical stress, which may be generated by the thick field-oxides used in the field-plate trenches, can potentially be reduced. Too high stress may generate increased wafer bow (which may affect safe wafer handling), generation of silicon defects (which may result in increased leakage), generation of process non-uniformities (such as inhomogeneous thickness of grown oxide layers) and/or even generation of cracks in the field-oxide at the trench bottom.

In addition, a staggered layout may result in a much more homogeneous local stress by avoiding the high mechanical stress which can occur in the middle of the diagonal of a square grid array in which the stress may lead to process non-uniformities in the gate oxide thickness of grown oxides. Also, silicon defects may be generated due to stress, for example for the higher voltage classes such as 200V. However, square needle layouts for the trenches and field plates or round or octagonal layouts may also be used. The proposed structure of the needle-shaped trench with a stepped field oxide is also applicable for an arrangement of needle trenches in an orthogonal layout. A structure with a tapered field oxide may also be used.

To achieve a design of the device that ensures an appropriate process window with respect to the breakdown voltage, the field-oxide thickness may be precisely controlled. This includes a precise control of the oxide thickness in the upper part of the trench. In an embodiment, the reduced thickness of the oxide in the upper part of the trench is achieved by an additional wet etch, in which case a type of `etch stop' may be usefully employed. In an embodiment, this is achieved by the use of the different etch rates of a thermally grown field-oxide and a deposited oxide. The field dielectric may be formed by the dielectric layers, e.g., a thermally grown field-oxide and a deposited oxide. The difference in etch rates of these layers can be used so that the oxide thickness of the field-oxide equals the thickness of the targeted reduced oxide thickness in the upper part of the trench, i.e., the field oxide in the upper part of the trench is provided by the thermally gown field oxide. The full oxide thickness used in the lower part of the trench is provided by an additional oxide layer deposited onto the thermally grown field oxide, for example by use of a TEOS deposition process to deposit a second oxide layer onto the thermally grown oxide layer. As the etch rate even of the TEOS layer is higher than that of the thermally grown oxide, an etch-stop is provided by the underlying thermally grown oxide layer. Subsequent to the etch process, the TEOS layer may be densified.

The needle trench reaches to the surface which allows for a simple process that is easier to control and enables cost savings. The combination with a stepped field oxide enables the use of a narrower ring-shaped (e.g., donut-like) groove contact. The benefits of the ring-shaped contact to the mesa may include process integration simplification because it may allow a single contact scheme and an increased lithographic process window because the mesa contact critical dimension is in a similar order of magnitude as the edge termination contact critical dimension. A stepped or tapered field oxide enables the ring-shaped contact as a thin field oxide in the upper needle part means that only a small mesa contact width is necessary to contact both the mesa and the field-plate.

In an embodiment, a process sequence to realize the groove contact comprises two etch steps - first opening an interlayer dielectric with an oxide etch, followed by doing a groove etch into the silicon.

A ladder arranged gate trench layout may be used for both an orthogonal and staggered design to improve the reliability of the gate dielectric, e.g. to reduce the number of crystalline planes at the gate dielectric.

Gate fins, i.e. an interrupted gate grid, instead of a continuous gate grid may be used. The proposed structure may also be used in combination with structural variants for gate charge optimization, i.e. individual gate strips with a current spread implant, or for hexagonal needles use of a zigzag gate trench, planar gate structures.

A suitable doping profile of the semiconductor substrate can also be used to improve device performance. In an embodiment, a graded epi profile is used where the doping continuously increases from the front surface towards the epi-substrate-junction and includes (at least) two parts with a different grading. The graded epi profile is located in the mesa laterally all around the needle trench, for example 360° around the needle trench of the basic cell.

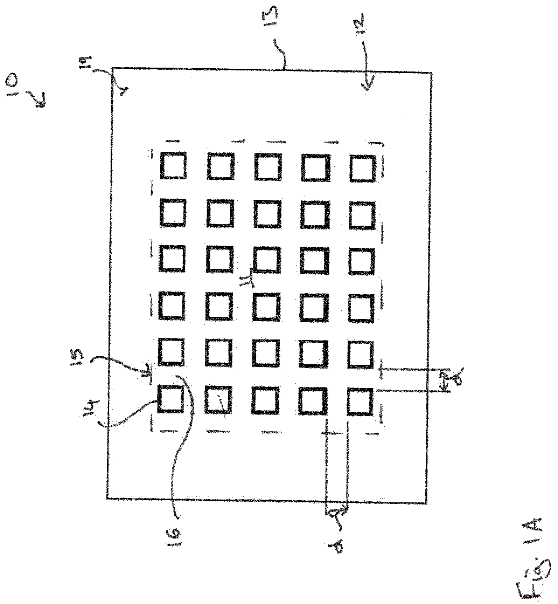

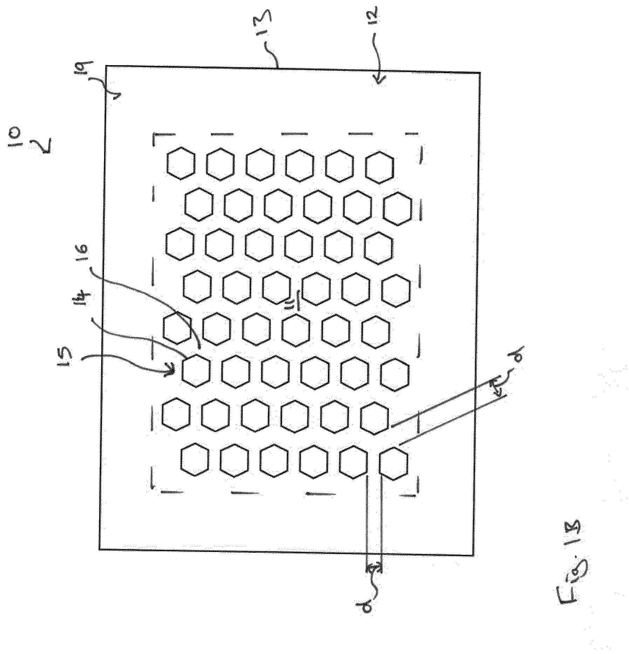

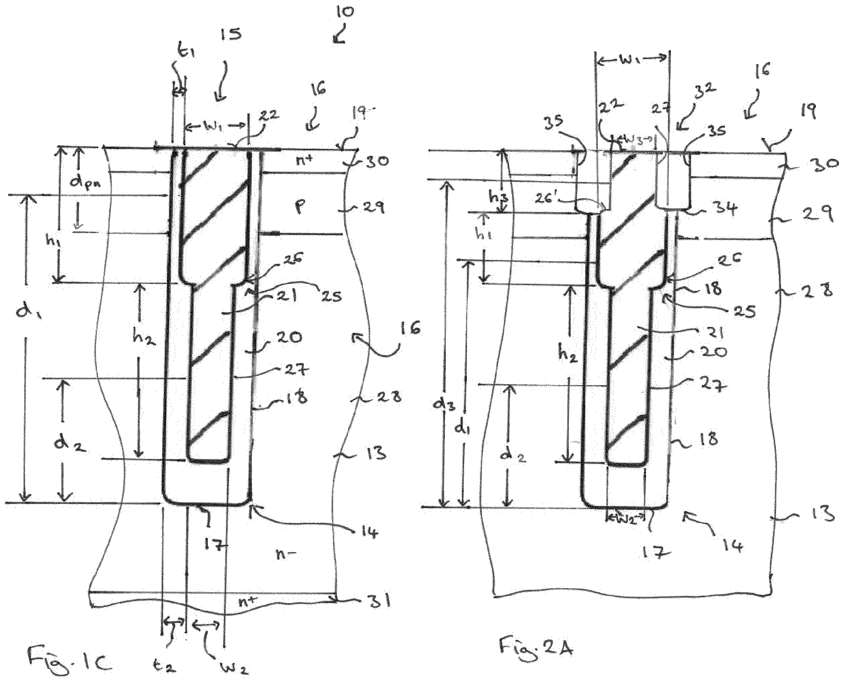

Figure 1A illustrates a top view of a semiconductor device 10 according to an embodiment, Figure 1B illustrates a top view of a semiconductor device 10 according to another embodiment. Figure 1C illustrates a cross-sectional view of a portion of the semiconductor device 10 of one or both of figures 1A and 1B. The semiconductor device 10 may be a transistor device, such as a vertical power MOSFET (Metal Oxide Semiconductor Field Effect Transistor) device.

Referring to the top view of figures 1A and 1B, the semiconductor device 10 includes an active area 11 and an edge termination region 12 that are positioned in a semiconductor substrate 13. The edge termination region 12 laterally surrounds the active area 11 on all sides. The semiconductor substrate 13 may be formed of silicon, for example monocrystalline silicon or an epitaxial silicon layer.

The semiconductor device 10 comprises one or more transistor cells 15 that are located in the active area 11. A plurality of active transistor cells 15 are electrically connected to one another in parallel to switch a load and provide a transistor device. The transistor device may be a power MOSFET device and may have a vertical drift path. Each transistor cell 15 comprises a columnar trench 14 and a mesa 16 that is formed by the portion of the semiconductor substrate 13 that laterally surrounds the columnar trench 14. As indicated in Figs. 1A and 1B, the semiconductor substrate may surround the columnar trench 14 on all sides of the columnar trench 14. Referring to the cross-sectional view of figure 1C, the columnar trench 14 has a small or narrow circumference or width in proportion to its height / depth in the substrate. For example, the depth is at least twice the width. A columnar trench 14 may also be called a needle-shaped trench or a needle trench or a spicular trench.

Referring to the top view of figures 1A and 1B, a plurality of columnar trenches 14 are provided that are arranged in an array. In the embodiment illustrated in figure 1A, the columnar trenches 14 are arranged in rows and columns that are arranged orthogonal to one another and that form a square grid array, where the pitch or spacing d between the columnar trenches 14 of each row and between the columnar trenches 14 of each column is substantially the same. The spacing between diagonally neighboring columnar trenches 14 is, however, greater than d. In the embodiment illustrated in figure 1B, the columnar trenches 14 are arranged in offset or staggered rows and form a hexagonal pattern in which the spacing d between adjacent columnar trenches 14 within each row (column) and between adjacent columnar trenches 14 in adjacent rows is substantially the same.

In the embodiment illustrated in figure 1A, the columnar trenches 14 are illustrated as having a square lateral form in top view. However, the columnar trench 14 may have other lateral forms in top view. For example, the columnar or needle trench 14 may have an octagonal, circular, or a hexagonal shape in plan view. Figure 1B illustrates an embodiment in which the columnar trenches 14 have a hexagonal shape in top view and are arranged in a hexagonal array.

In cross-section, the columnar trenches 14 may have the same structure irrespective of the pattern of the array or the lateral shape of the columnar trench 14 and columnar field plate 21. Figure 1C illustrates a cross-sectional view of one of the columnar trenches 14 of the semiconductor device of figures 1A and 1B.

Referring to the cross-sectional view of figure 1C, the individual ones of the columnar trenches 14 comprise a base 17 and a side wall 18 that extends from the base 17 to the first major surface 19 of the semiconductor substrate 13. The individual ones of the columnar trenches 14 also comprise a field dielectric 20 that lines the base 17 and side wall 18 of the columnar trench 14. A columnar electrically conductive field plate 21 is arranged in and fills each columnar trench 14 and is electrically separated from the semiconductor substrate 13 by the field dielectric 20. The field plate 20 extends to the first major surface 19 and has an upper surface 22 that is coplanar with the first major surface 19 of the semiconductor substrate 13.

The field dielectric 20 has a first thickness t₁ at a first distance d₁ from the base 17 and a second thickness t₂ at a second distance d₂ from the base 17 of the columnar trench 14. The first thickness t₁ is smaller than the second thickness t₂. The first distance d₁ is greater than the second distance d₂. Therefore, the field dielectric 20 is thinner at a position towards the top of the trench 14 and is thicker towards the base 17 of the trench 14. The difference between the thicknesses t₁ and t₂ is greater than that arising from process variations. In some embodiments, t₁ ≤ 1.15 t₂ and consequently greater than typical process variations. In some embodiments, the difference is greater so that t₁ ≤ 1.2 t₂ or t₁ ≤ 1.5 t₂.

The field dielectric 20 may include one or more sublayers having the same or differing compositions. The field dielectric 20 may be an oxide, SiOₓ, for example. The field plate 21 is electrically conductive and may be formed of polysilicon, for example. The columnar field plate 21 has a first perimeter at the first distance d₁ from the base 16 of the columnar trench 14 and a second perimeter at the second distance d₂ from the base 17. The first perimeter is greater than the second perimeter, i.e., the length l₁ of the first perimeter is greater than the length l₂ of the second perimeter. The difference between the first and second perimeters is greater than that arising from process variations. In some embodiments, l₁ ≥ 1.15 l₂ and consequently greater than typical process variations. In some embodiments, the difference is greater so that l₁ ≥ 1.2 l₂ or l₁ ≥ 1.5 l₂. In other words, the field plate 21 is laterally wider at the first distance d₁ compared to the second distance d₂ from the base 16. As the field plate 21 and the field dielectric 20 together fill the columnar trench 14, the field plate 21 has a larger width w₁ in the upper portion of the trench 14 than its width w₂ in the lower portion of the trench 14. In cross-section, the field plate 21 may have a T-shape or a tapered V-shape.

The field plate 21 may have the same lateral shape as the columnar trench 14, e.g. square or hexagonal, respectively, in the embodiments shown in figures 1A and 1B. Alternatively, the field plate 21 may have a different lateral shape from that of the columnar trench 14, for example the field plate 21 may have a circular shape in top view and be located in a columnar trench 14 with a hexagonal shape in top view.

In embodiments in which the columnar trench 14 is circular in plan view, the columnar trench 14 has a single side wall 18. If the columnar trench 14 is square in plan view, as shown in figure 1A, the side wall 19 is divided into four side wall sections that are arranged substantially perpendicularly to one another. If the columnar trench 14 is hexagonal in plan view, as shown in figure 1B, the side wall 19 has six side wall sections. If the columnar trench 14 is octagonal in plan view, the side wall 18 has eight side wall sections etc.

Referring to figure 1C, in some embodiments, the field dielectric 20 comprises an abrupt transition from the first thickness t₁ to the second thickness t₂ that forms a step 25 so that the field dielectric 20 can be considered to have a stepped shape. In some embodiments, the field dielectric 20 has the smaller thickness t₁ over a first height h1 of the columnar trench 14 in the upper portion and the larger thickness t₂ over a second height h₂ of the columnar trench 14 in the lower portion.

The field plate 21 also has an abrupt transition between a larger width w₁ in the upper portion of the trench 14 and a smaller width w₂ towards the lower portion of the trench 14. The field plate 21 can be considered to have a step 26 in its outer surface 27 corresponding to the step 25 formed in the field dielectric 20. The field plate 21 illustrated in figure 1C can be considered to have a T-shape in cross-section.

The mesa 16 of each transistor cell 15 is formed by the region of the semiconductor substrate 13 that laterally surrounds the columnar trench 14 of that active transistor cell 15. As illustrated in figure 1C, in the active area 11 each mesa 16 comprises a drift region 28 of the first conductivity type, for example n-type, and a body region 29 of the second conductivity type, for example p-type if the drift region is n-type. The body region 29 is arranged above the drift region 28 and forms a pn junction with the drift region 20. The mesa 16 also comprises a source region 30 of the first conductivity type that is arranged on and forms a pn junction with body region 29. A drain region 31 of the first conductivity type, which is more highly doped than the drift region 28, is arranged on a second major surface 32 of the semiconductor substrate 13, the second major surface 32 opposing the first major surface 19. A gate electrode, which is not shown in figure 1C, is located on or in the mesa 16 and electrically separated from the mesa 16 by a gate dielectric.

In some embodiments, the field dielectric 20 has the first thickness t₁ in a first region of the side wall 18 that is contiguous to the body region 29 and the second thickness t₂ in a second region of the side wall 18 that is contiguous to the drift region 28. The step 25 is located at a depth d from the first major surface 19 of the semiconductor substrate 13 that corresponds to the height h₁. The pn junction formed between the body region 29 and the drift region 28 is located a depth dₚₙ from the first major surface of the semiconductor substrate, wherein h₁ > dₚₙ. The step 25 is positioned laterally adjacent the drift region 28.

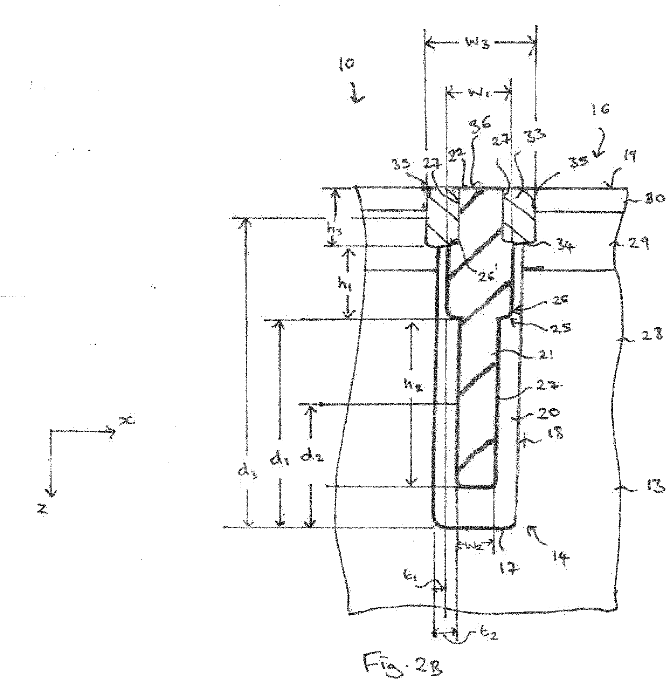

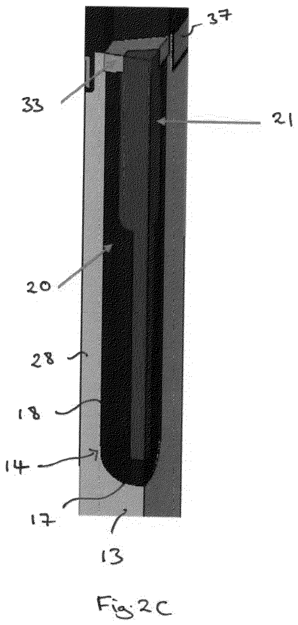

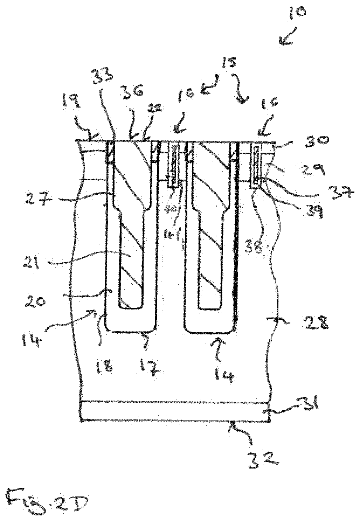

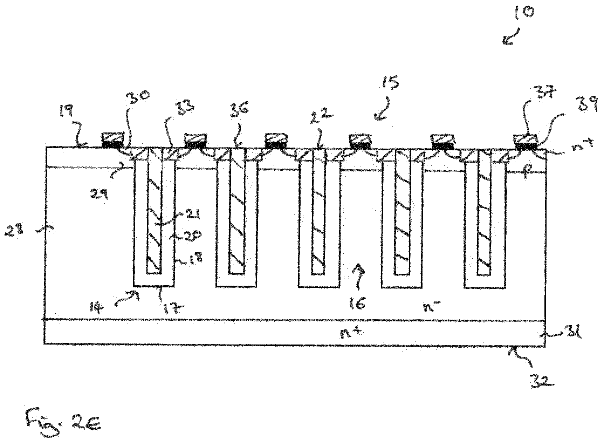

Figure 2, which includes figures 2A to 2E, illustrate cross-sectional views of a columnar trench 14 according to various embodiments. The columnar trench 14 comprises an electrically conductive field plate 21 that is electrically separated from the semiconductor substrate 13 by a field dielectric 20. The columnar trench 14 of any one of these embodiments may be used as part of a transistor cell 15, for example the transistor cells 15 of the transistor device 10 illustrated in figure 1A or figure 1B.

Referring to figure 2A, in this embodiment, the columnar trench 14 differs from that illustrated in figure 1C in that the columnar field plate 21 has a third perimeter which is positioned at a third distance d₃ from the base 17 of the columnar trench 14. The third perimeter is smaller than the first perimeter. In other words, the length l₃ of the third perimeter is less than the length of the first perimeter l₁ by an amount that is greater than that arising from processing variations. In this embodiment, the third distance d₃ from the base 17 is larger than the first distance d₁ from the base 17 such that the third parameter l₃ is positioned closer to the first major surface 19 than the first perimeter l₁.

In the embodiment illustrated in figure 2A, the field plate 21 includes a third section having a width w₃ which is positioned adjacent to the first major surface 90. The third portion has the third width w₃ over a height h₃ and is positioned between the first major surface 19 and the middle portion of the field plate 21 that has the width w₁. The width w₃ is smaller than the width w₁ by an amount that is greater than that arising from processing variations. A shoulder 26' is formed between the side face 27 of the upper and middle portions of the field plate 21. The shoulder 26' forms part of the base 34 of the recess 32.

Additionally, in this embodiment, the columnar trench 14 includes an enlarged recess 32 which is laterally adjacent to the first major surface 19 and which extends into the semiconductor substrate 13 by a distance which corresponds to the height of the third portion of the field plate. The base 34 of the recess 32 may be positioned laterally adjacent to the body region 29 and be positioned at a distance h₃ from the first major surface 19.

The side wall 18 of the columnar trench 14 has a step formed between the lower narrower portion and the enlarged recess 32 formed in the first major surface 19. The step forms the base 34 of the recess 32 and has a continuous ring-shape. The field plate 21 extends to the first major surface 19 of the semiconductor substrate 13 so that its upper surface is substantially coplanar with the first major surface. The portion of the enlarged recess 32 that is unoccupied by the field plate 21 has a ring-shape and laterally surrounds the field plate 21.

The recess 32 may be used to from a contact to the field plate 21. Referring to the cross-sectional view of figure 2B and the perspective cross-sectional view of figure 2C, conductive material is formed in the recess 32 to form an electrically conductive contact 33. The contact 33 is located at least partly within the columnar trench 14 and extends between the side face 27 of the field plate 21 and the side wall 35 of the recess 32. In some embodiments, the contact 33 is positioned entirely within the columnar trench 14 and has an upper surface that is coplanar with the upper surface 22 of the field plate 21 and with the first major surface 19. The contact 33 has a ring-shape and is in continuous and uninterrupted contact with the side face 27 of the field plate 21 and with the side wall 18 of the trench and therefore with the surrounding mesa 16. Since the sidewall 35 of the recess 32 is formed by the source region 30 and the body region 29, the contact 33 electrically connects the field plate 21 to the body region 29 and the source region 30 in the mesa 16. The ring-shaped contact 33 extends over the entire width t₁ of the field dielectric 21 that is positioned on the sidewall 18 of the columnar trench 14 in the underlying portion of the columnar trench 14. The width of the ring-shaped contact 33 corresponds to the spacing between the side face 27 of the field plate 21 and the side wall 35 of the enlarged recess 32 and is greater than the first thickness t₁ of the field dielectric 20.

In some embodiments, the central region 36 of the upper surface 22 of the field plate 21 remains uncovered by the contact 33 and also remains uncovered by any other conductive material. In other words, the contact to the field plate 21 is formed solely at the perimeter of the field plate 21 at a position within the columnar trench 14 rather than by a contact positioned intermediate the width and intermediate the lateral area of the field plate 21 or by a contact that is in direct contact with the upper surface of the field plate 21. The contact 33 can be considered to be a buried contact as it is positioned within the columnar trench 14 and below the first major surface 19 of the semiconductor substrate 23.

The ring-shaped contact 33 may have different lateral forms, for example, circular, square, hexagonal, octagonal in plan view. The lateral form of the ring-shaped contact 33 depends on the lateral form of the columnar trench 14 and the columnar field plate 21. For example, for a circular columnar trench 14 and a circular field plate 21, the contact 33 may have a circular ring-shape. For a hexagonal columnar trench 14 and a hexagonal field plate 21, the contact 33 may have a hexagonal ring-shape. The ring-shaped contact 33 may comprise two or more sublayers which may have differing compositions and/or may be formed of tungsten. For example, one or more barrier layers, e.g. TiN may be formed and then the recess filled with tungsten.

In the perspective cross-sectional view of the columnar trench 14 of figure 2C, the lateral form of the columnar trench 14 and the field plate 21 can be seen to be hexagonal. The contact 33 has a continuous hexagonal ring-shaped form and completely covers the field dielectric 20 located between the side face 27 of the field plate 21 and the sidewall 18 of the columnar trench 14, in particular the side wall 35 of the recess 32 of the columnar trench 14.

In a variation of the embodiment described with reference to and illustrated in figures 2B and 2C, the contact 33 is formed as part of the field plate 21 so that there is no distinguishable interface between the enlarged upper portion of the field plate 21 that provides the contact 33 with the body region 29 and source region 30 and the remainder of the field plate 21. The field plate 21 comprises an integral contact portion 33 in its upper portion and the upper surface 22 of this integral contact 33 is coplanar with the first major surface 19. In these embodiments, the columnar field plate 21 has a third perimeter which is positioned at a third distance d3 from the base 17 of the columnar trench 14. The third perimeter is larger than the first perimeter. In other words, the length l3 of the third perimeter is greater than the length of the first perimeter l1 by an amount that is greater than that arising from processing variations. In this embodiment, the third distance d3 from the base 17 is larger than the first distance d1 from the base 17 such that the third parameter l3 is positioned closer to the first major surface 19 than the first perimeter.

The field plate 21 includes a third upper section having a width w₃ which is greater than the width w₁ by an amount that is greater than that arising from processing variations. The contact portion 33 of the field plate 21 has the third width w₃ over a height h₃ and is positioned between the first major surface 19 and the middle portion of the field plate 21 that has the width w₁. A shoulder 26' is formed between the side face 27 of the upper and middle portions of the field plate 21.

Figure 2D illustrates a cross-sectional view of a transistor device 10 and illustrates two transistor cells 15, each including a columnar trench 14 and mesa 16 laterally surrounding the trench 14. In this embodiment, the columnar trench 14 differ from that of figures 2B and 2C in that it does not include a recess at the top end. The width and area of the columnar trench 14 is substantially uniform over its depth from the first major surface 19 to its base 17.

In some embodiments, each columnar trench 14 has a field plate 21 with a single abrupt transition or step 26 in the side face 27 having the shape illustrated in figure 1C and the ring-shaped contact 33 is positioned within each of the columnar trenches 14. In this embodiment, the contact 33 has a width which is substantially the same as the width of the first thickness t1 of the field dielectric 20 and contacts the entire perimeter of the field plate 21 and the side wall 18 of the columnar trench 14 continuously and uninterruptedly. The ring-shaped contact 33 is positioned within the columnar trench 14 and extends from the side face 27 of the field plate 21 to the side wall 18 of the columnar trench so as to electrically connect the field plate 21 to the mesa 16 and to the body region 29 and source region 30 at a position below the first major surface 19. The contact 33 has an upper surface which is substantially coplanar with the upper surface 22 of the field plate 21 and with the first major surface 19.

Figure 2D also illustrates the gate electrode 37 of the transistor cell 15 which is positioned in a gate trench 38 formed in the mesa 16 such that the gate trench 38 is positioned equidistantly and from two neighbouring ones of the columnar trenches 14. The gate electrode 37 is electrically separated from the semiconductor substrate 13 by a gate dielectric 39 which lines the base 40 and sidewalls 41 of the gate trench 38.

Figure 2E illustrates an embodiment of a columnar trench 14 and field plate 21 in which the columnar field plate 21 has a substantially uniform width over the entire height from the lower surface to the first major surface 19. In this embodiment, each of the columnar trenches 14 includes a ring-shaped contact 33 which is positioned within the trench 14 and which extends from the side face 27 of the field plate 21 over the field dielectric 20 to the side wall 18 of the columnar trench 14 where is in contact with the mesa 16. The columnar trench 14 may also include a recess which extends into the mesa 16. As the contact 33 fills this recess, the contact 33 is laterally wider than the remainder of the columnar trench 14 and has a width which is greater than the thickness of the field dielectric 20.

In the embodiment illustrated in figure 2E, the transistor device 10 includes a planar gate structure in which a conductive gate electrode 37 is positioned on the mesa 16 and in particular on the first major surface 19 of the semiconductor substrate 13 which forms the mesa 16. The conductive gate electrode 37 is electrically separated from the semiconductor substrate 13 by an intervening gate dielectric layer 38 arranged on the first major surface 19. However, the gate electrode 37 may also be positioned in a gate trench. A planar gate may also be used in place of the gate trench structure in the embodiments illustrated in figures 1, 2A to 2D and 3 to 6.

In any one of the embodiments described herein, the thickness of the field dielectric 20 located on the base 17 and the lower portion of the sidewall 18 of the columnar trench 14 may be substantially uniform, or the thickness of the field dielectric arranged on the base 16 of the columnar trenches 14 is greater than that of the greatest thickness of the field dielectric 20 arranged on the sidewall 18 of the trench 14.

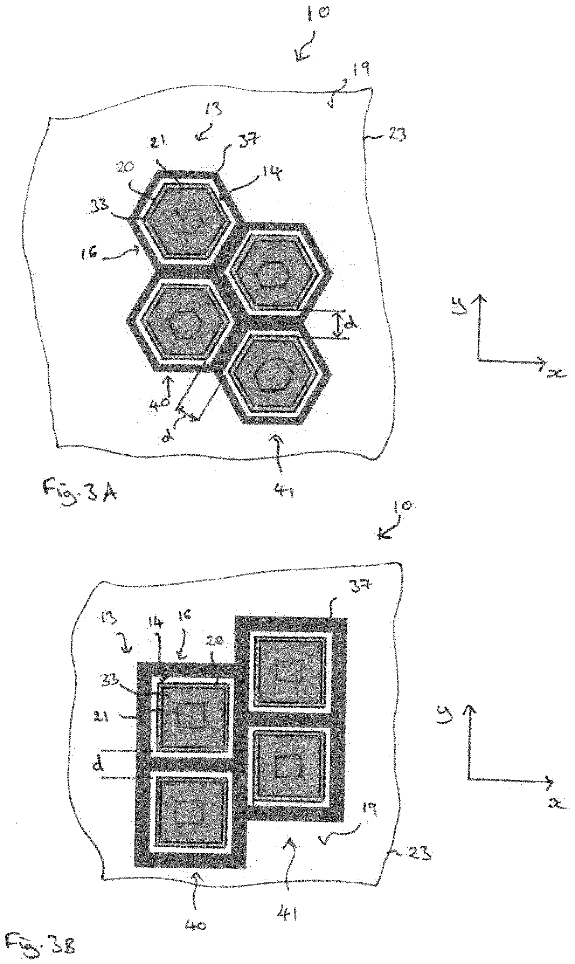

Figure 3, which includes figures 3A to 3B, illustrates a top view of a portion of the first major surface 19 of the semiconductor substrate 23 illustrates a cross-sectional view of a transistor device 10 in which having a plurality of columnar trenches 14 each including a field plate 21 and field dielectric 20. The columnar trenches 14 may have the structure shown in figures 2B and 2C. Figure 3A and 3B each illustrate the lateral arrangement of four transistor cells 15 arranged in two rows 40, 41.

In the embodiment shown in figure 3A, each of the transistor cells 15 includes a columnar trench 14 which has a hexagonal shape in the top view. The columnar trenches 14 are arranged in rows, of which two rows 40 ,41 are illustrated in figures 3A and 3B. Using the Cartesian coordinate system, the columnar trenches 14 are aligned in each row 40 and 41 in the y direction. The columnar trenches 14 of the neighbouring rows 40, 41 are not aligned with one another in the x direction but offset from one another in the y direction typically by half of the pitch d, i.e. d/2. Thus, the array or layout of trenches 14 comprises offset or staggered rows. The spacing or pitch d between adjacent ones of the columnar trenches 14 within one row 40 and between adjacent ones of the columnar trenches 14 in adjacent rows 40, 41 is substantially the same. The columnar trenches 14 are arranged in a hexagonal array.

Each of the columnar trenches 14 comprises a columnar field plate 21 which also has a hexagonal shape in plan view, as in the embodiment of figures 2B and 2C. As can be seen in top view of figure 3A, the contact 33 extends around and is in contact with the perimeter of the field plate 21 and also has a hexagonal ring form. The lateral form of the gate electrode 37 and, in embodiments including a trench gate arrangement, the gate trench 38 can also be seen in figure 3A. In this embodiment, the gate electrode 37 also has a hexagonal ring form and is positioned concentrically around each of the columnar trenches 14 in the mesa 16 and is spaced apart from the columnar trench 14 by a portion of the mesa 16. The gate electrode 37 can be considered to comprise a plurality of hexagonal rings, one arranged concentrically with each of the hexagonal columnar trenches 14. These hexagonal rings are connected to one another or form a common gate at positions between adjacent ones of the columnar trenches 14 so that the gate electrode 37 has a continuous structure and has a continuous hexagonal grid structure.

Figure 3B illustrates a top view of a portion of a first major surface 19 of the semiconductor substrate 13 of a transistor device 10 according to another embodiment. In this embodiment, the columnar trenches 14 have a square shape in top view. This embodiment, the field plate 21 in each of the columnar trenches 14 also has a square shape. The contact 33 has a continuous uninterrupted ring-shape and extends from the side face 27 of the field plate 21 to the side wall 18 of the columnar trench 14. The contact 33 has a ring-shape that is laterally square. The gate electrode 37 also has a square ring shape and is arranged concentrically and spaced apart from each of the columnar trenches 14. The square-shaped sections around neighbouring ones of the columnar trenches 14 contact one another to form a continuous square grid.

In the embodiment illustrated in figure 3B, the columnar trenches 14 are arranged in offset or staggered rows. Consequently, the square rings of one row 40 are aligned in the y direction and are offset from the square rings of the next row 41 of the array located in the x direction. Using the cartesian coordinate system, the rings of neighbouring rows 40, 41 are offset from one another in the Y direction, typically by half of the pitch d, i.e. d/2.

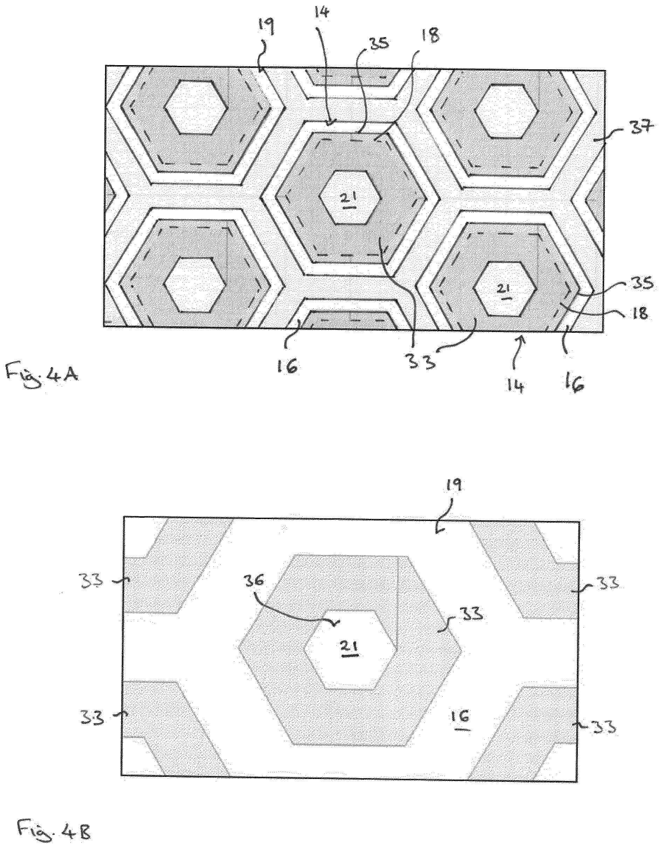

Figure 4A and 4B show an enlarged view top view of one of the columnar trenches 14 of figure 3A whereby figure 4A shows the laterally hexagonal columnar trench 14, the laterally hexagonal field plate 21 and laterally hexagonal ring-shaped contact 33. Figure 4B illustrates the metallic portions of the ring-shaped contact 33 only. The ring-shaped contact 33 leaves the central portion of the field plate 21 uncovered and extends over the recessed portion of the field plate 21 and over the field dielectric 20 and into the recessed portion of the mesa 16.

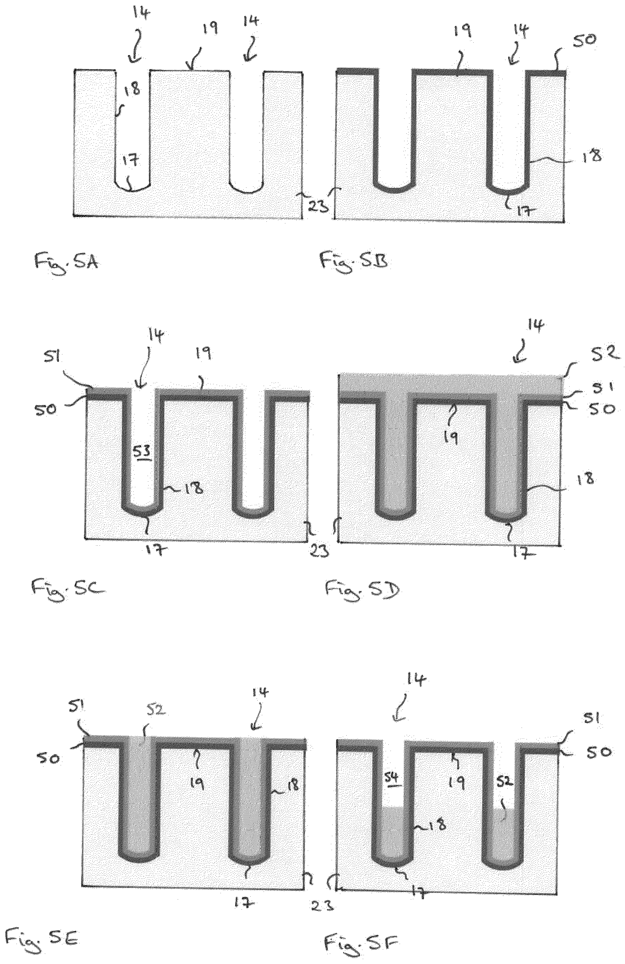

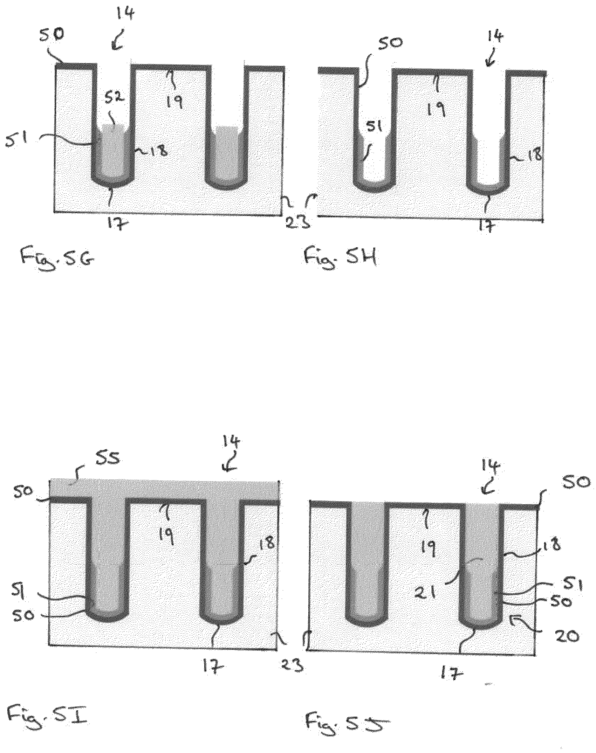

Figure 5 which includes figures 5A to 5J illustrates a method of fabricating a columnar trench 14 having a field dielectric 20 and a field plate 21 having the form illustrated in figure 1C and figures 2A to 2C.

Referring to figure 5A, a plurality of columnar trenches 14 are formed in the first major surface 19 of the semiconductor substrate 13. The semiconductor substrate 13 is formed of silicon, for example monocrystalline silicon or epitaxial silicon grown on a substrate and comprises the first conductivity type. Each of the columnar trenches 14 has a depth which is greater than its maximum width, for example at least twice as great as a maximum width. The columnar trenches 14 may have different lateral forms, e.g. circular, square, hexagonal or octagonal.

Referring to figure 5B, a first dielectric sublayer 50 is formed on the exposed surface of the semiconductor substrate 13 which covers the base 17 and sidewall 18 of the columnar trenches 14 as well as the first major surface 19. The first dielectric sublayer 50 may be formed by thermal growth, that is thermal oxidation of silicon, for example by thermal annealing of the silicon substrate 23 and may be formed of silicon dioxide.

Referring to figure 5C, a second dielectric sublayer 51 is deposited onto the first dielectric sublayer 50 such that it covers the base 17 and sidewall 18 of the columnar trenches 14 and also the first major surface 19. The second dielectric sublayer surrounds a gap 53 formed in the columnar trench 14. The second dielectric layer 51 may be deposited using a TEOS (Tetra Ethyl Ortho Silicate) process, for example.

Referring to figure 5D, a material 52 is then applied which fills the gap 53 in the central region of the columnar trenches 14 and also covers the first major surface 19. The material 52 may be electrically conductive, for example polysilicon and may be selected so as to be suitable for forming the field plate within the columnar trenches 14. In other embodiments, the material 52 may be a sacrificial material which is subsequently entirely removed at a later stage in the process. The material may be electrically conductive or insulative. For example, the material 52 may be photoresist and electrically insulative. In another example, the sacrificial material, which is subsequently entirely removed at a later stage in the process, may be formed from the same material as the field plate, for example polysilicon.

The material 52 should be selectively removable over the material of at least the second dielectric sublayer 51 and optionally also over the material of both the first and second dielectric sublayers 50, 51. For example, the material 52 should be selectively etchable, that is have a higher etch rate, than the first and second dielectric sublayers 50, 51, for a particular etch and/or particular etch conditions.

Referring to figure 5E, in some embodiments, a planarisation process is then carried out to remove the material 52 from the first major surface 19 and expose the second dielectric sublayer 51 which is arranged on the first major surface 19. Referring to figure 5F, a portion of the material 52 is then removed from the upper portion of the columnar trench 14 to form a recess 54 which is lined by the second dielectric layer 51 arranged on the sidewall 18 of the upper portion of the columnar trench 14 and which has a base formed by the remainder of the material 52 arranged on the lower portion of the columnar trench 14.

Referring to figure 5G, the exposed portion of the second dielectric sublayer 51 is removed from the sidewall 18 of the columnar trench 14 and from the first major surface 19 thus exposing the underlying first dielectric sublayer 50. The first and second dielectric sublayers 50, 51 are formed of materials which have differing etching rates so that the second dielectric sublayer 51 can be preferentially or selectively removed over underlying the first dielectric sublayer 50. This may be achieved by selection of different materials or by the use of different formation routes of the same material. For example, the first dielectric layer 50 may be a thermally grown silicon dioxide layer and the second dielectric sublayer 51 may be silicon dioxide formed by a TEOS deposition-process. Silicon dioxide formed by a TEOS process has a higher etch rate than silicon dioxide formed by thermal growth. Thus, the first dielectric layer 50 formed by thermal growth can be used as an etch stop allowing the preferential removal of the second dielectric sublayer 51 over the first dielectric sublayer 50 and also over the material 52.

In some embodiments, an upper portion of the second dielectric layer 51 that is arranged between the remaining material 52 and the side wall 18 of the columnar trench 14 is removed so that the upper portion of the remainder of the material 52 protrudes above the remainder of the second dielectric sublayer 51 arranged towards the bottom of the columnar trench 14. In some embodiments, in which the material 52 comprises the material of the field plate, method continues by inserting conductive material into and filling the columnar trenches 14 to form the field plate 21. In other embodiments, the method continues as shown in figure 5H.

Referring to figure 5H, the remainder of the material 52 is removed from the columnar trenches 14 thus providing a columnar trench 14 in which the base 17 and entire sidewall 18 are covered by the first dielectric sublayer 50 and in which the second dielectric sublayer 51 is arranged only on the base 16 and lower portion of the sidewall 18. Thus, the columnar trench 14 is lined with a thicker dielectric layer in the lower portion of the columnar trench 14 than in the upper portion of the columnar trench 14. This dielectric layer with non-uniform thickness provides the field dielectric 20 in the final transistor device.

Referring to figure 5I, conductive material 55 is then inserted into and fill the trenches 14 and also covers the first major surface 19. A planarisation process is then carried out, as shown in figure 5J, to remove the conductive material 55 from the first major surface 19 and form individual columnar field plates 21 in each of the columnar trenches 14. Each of the field plates 21 has a first perimeter in the upper portion of the trench 14 which is greater than a second perimeter of the field plate 21 in the lower portion of the trench 14. The field plate 21 has a step 26 in its side face 27 between the narrower lower portion and the wider upper portion. Similarly, the field dielectric 20 includes a step 25 between the field dielectric 20 in the lower portion of the trench 14 that is formed by the two dielectric sublayers 50, 51 and in the upper portion of the trench 14, where the field dielectric 20 is formed by the first dielectric sublayer 50 only. The field dielectric 20 has a smaller width in the upper portion of the trench 14 than in the lower portion of the trench 14. The first dielectric sublayer 50 may provide the thickness t₁ and the first and second dielectric sublayers 50 51, together provide the thickness t₂ of the field dielectric 20 of the columnar trench illustrated in any one of figures 2A to 2D.

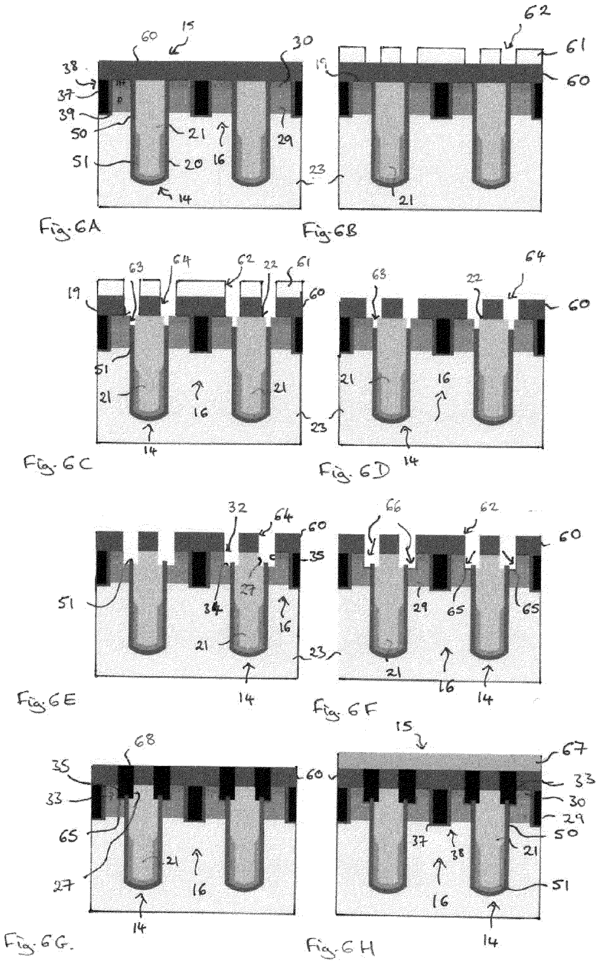

Figure 6, which includes figures 6A to 6H, illustrates a method for fabricating a ring-shaped contact to the columnar field plate located within a columnar trench. The method described with reference to figure 6 may be carried out after the method described with reference to figure 5 but may also be used for semiconductor devices including a columnar field plate in a columnar trench which have been fabricated by methods other that illustrated and described with reference to figure 5. The method may be used to form the ring-shaped contact 33 of the transistor cells 15 of the semiconductor device 10 illustrated in and described with reference to figures 2B to 2E, 3 and 4.

Referring to figure 6A, after fabrication of the columnar trenches 14 with a field plate 21, the transistor structure of the transistor cells 15 may be completed by implanting dopants of the second conductivity type into the first major surface 19 of the semiconductor substrate 13 to form the body region 29 and dopants of the first conductivity type to form a source region 30 on the body region 29. The gate trench 38 may be formed in the mesas 16, lined with a gate dielectric 39 and filled with conductive material to form the gate electrode 37 in the gate trench 38. Alternatively, a planar gate 37 may be formed on the first major surface 19 of the semiconductor substrate 23. The first major surface 19 is then covered by an electrically insulating layer which may be a first interlayer dielectric (ILD) 60 of metallization structure formed on the first major surface 19 of the semiconductor substrate 23. In examples, the gate trench or the planar gate may also be formed after the method steps described with regard to Fig. 6.

Referring to figure 6B, a mask 61 is formed on the first interlayer dielectric 60 and openings 62 are formed in the mask 61 exposing the first interlayer dielectric 60. The openings 62 are arranged so that each opening 62 is arranged above a columnar trench 14. The openings 62 each have a ring-shaped form with an outer wall that is positioned above the mesa 16 that laterally surrounds the columnar trench 14 and an inner wall that is positioned above the upper surface 22 of the field plate 21. The central region of the upper surface 22 of the field plate 21 is covered by the mask 61.

Referring to figure 6C, the regions of the interlayer dielectric 60 that are exposed by the openings 62 are removed, for example by etching, to form an opening 64 having a size that substantially corresponds to that of the opening 62. The opening 64 exposes the periphery of the upper surface 22 of the field plate 21, the first dielectric sublayer and the region of the first major surface 19 contiguous to the columnar trench 14. Portions of the first dielectric sublayer 51 which are positioned on the uppermost portion of the sidewall 18 of the columnar trench 14 are then removed to form a recess 63 in the upper portion of the columnar trenches 14 which extends between the side face 27 of the field plate 21 and the side wall of the columnar trench. The side face 27 of the field plate 21 and the side wall 18 of the columnar trench 14 are exposed from the first dielectric sublayer 50.

The referring to figure 6D, the mask 61 is then removed. The peripheral region of the upper surface of the field plate 21 and portion of the mesa 16 that is contiguous to the columnar trench 14 are exposed by the opening 64 in the interlayer dielectric 60

Referring to figure 6E, the interlayer dielectric 60 with its opening 64 is used as a mask and a further etch process is carried out. The width of the recess 63 is increased by removing the exposed contiguous portions of the mesa 16 and exposed peripheral portions of the of the field plate 21 to form the enlarged ring-shaped recess 32 at the top of the columnar trench 14. In some embodiments, the first dielectric layer 50 within the trench 14 may protrude above the base 34 of the recess 32. The field plate 21 now has an upper portion with a third perimeter positioned vertically adjacent the first major surface 19. The third perimeter is smaller than the first perimeter of the middle portion of the field plate 21. The lower portion of the field plate 21 has the second perimeter that is smaller than the first perimeter.

Referring to figure 6F, in some embodiments, a contact implantation may take place into the periphery of the base 34 of the recess 32, as indicated schematically by the arrows 66, and into the body region 29 to form a contact region 65 of the second conductivity type which is more highly doped than the body region 29.

Referring to figure 6G, conductive material 66 is then inserted into the recess 32 to form the ring-shaped contact 33 which extends between the side face 27 of the field plate 21 and the side wall 35 of the recess 32 and which electrically connects the field plate 21 to the body region 29 and source region 30 at a position within the columnar trench 14. In some embodiments, the ring-shaped contact 33 electrically connects the field plate 21 to the body region 29 and source region 30 at a position solely within the columnar trench 14.

A further interlayer dielectric layer 67 may then be deposited, as shown in figure 6H, which covers the field plate 21, the ring-shaped contact 33 and first major surface 19 of the semiconductor substrate 23. The interlayer dielectric 60 not only forms the mask for forming the enlarged ring-shaped recess 32 at the top of the columnar trench 14 but also provides part of the metallization structure of the transistor device.

To summarise, a transistor device with needle trench structures is provided which may enable a further reduction of the RDS(on) x Area. The needle trench structure may be used for transistor devices operating in a medium-voltage range, for example from around 25V to 300V. The needle trench and the electrically conductive field plate reaches to the surface which allows for a simple process that is easier to control and enables cost savings. This enables the use of a ring-shaped groove contact which enables the field plate to be electrically connected to the body region and source region of the transistor structure solely within the columnar trench and below the surface of the semiconductor substrate. The ring-shaped contact may provide a buried contact between the field plate and the body and source regions.

The combination of a reduced thickness in the upper portion of the columnar trench in combination with the extension of the field plate to the surface enables the use of a narrower ring-shaped groove contact, with which the field plate is electrically connected to the body region and source region of the transistor structure solely within the columnar trench and below the surface of the semiconductor substrate, which is also easier to manufacture.

Although the present disclosure is not so limited, the following numbered examples demonstrate one or more aspects of the disclosure.

### Examples

Example 1. A transistor device, comprising:
a semiconductor substrate having a first major surface; and
one or more transistor cells, each transistor cell comprising:
   a columnar trench formed in the semiconductor substrate, wherein the columnar trench comprises a field dielectric, a base and a side wall, wherein the side wall extends from the base to the first major surface and the field dielectric lines the base and side wall of the columnar trench, wherein a first thickness of the field dielectric at a first distance from the base is smaller than a second thickness of the field dielectric at a second distance from the base, wherein the first distance is greater than the second distance;
   a columnar field plate arranged in the columnar trench, wherein a first perimeter of the columnar field plate at the first distance is greater than a second perimeter of the columnar field plate at the second distance; and
   a mesa arranged around the columnar trench.

Example 2. The transistor device of example 1, further comprising a contact located at least partially within the columnar trench and forming an electrical contact between the field plate and the mesa.

Example 3. The transistor device of example 2, wherein a central region of the field plate remains uncovered by the contact.

Example 4. The transistor device of any one of examples 1 to 3,
wherein a third perimeter of the columnar field plate at a third distance from the base is smaller than the first perimeter,

Example 5. The transistor device of any one of examples 1 to 3, wherein a third perimeter of the columnar field plate at a third distance from the base is smaller than the first perimeter to form a contact that is integral with the field plate.

Example 6. The transistor device of example 4 or example 5, wherein the third distance is greater than the first distance.

Example 7. The transistor device of any one of examples 2 to 6, wherein the contact has a width that is greater than the first thickness of the field dielectric.

Example 8. The transistor device of any one of examples 2 to 7, wherein the contact comprises a ring-shape.

Example 9. A transistor device, comprising:
a semiconductor substrate having a first major surface;
a plurality of transistor cells, each transistor cell comprising:
   a columnar trench formed in the semiconductor substrate and a mesa, wherein the columnar trench comprises:
      a base and a side wall extending from the base to the first major surface, a field dielectric that lines the base and side wall of the columnar trench and a field plate arranged in the columnar trench;
   a ring-shaped contact that extends from the periphery of the field plate over the field dielectric to the semiconductor substrate.

Example 10. A transistor device according to example 9, wherein the ring-shaped contact is in electrical contact with the field plate and the mesa.

Example 11. A transistor device according to example 9 or example 10, wherein the ring-shaped contact is located within the trench and is in contact with the side face of the field plate.

Example 12. A transistor device according to any one of examples 9 to 11, wherein the central region of the field plate remains uncovered by the contact.

Example 13. A transistor device according to any one of claims 9 to 12, wherein the contact has a width that is greater than a thickness of the field dielectric at the top of the columnar trench.

Example 14. The transistor device of any one of examples 9 to 13, wherein the contact has a width that is greater than the thickness of the field dielectric.

Example 15. The transistor device of any one of examples 1 to 14, wherein the contact is located entirely within the columnar trench.

Example 16. The transistor device of any one of examples 1 to 15, wherein the columnar trench comprises a circular shape, a square shape, a hexagonal shape or an octagonal shape in plan view and the contact comprises a circular ring or a square ring, or a hexagonal ring or an octagonal ring in top view, respectively.

Example 17. The transistor device of any one of examples 1 to 18, wherein the mesa comprises a drift region of a first conductivity type, a body region of a second conductivity type that opposes the first conductivity type, the body region being arranged on the drift region, and a source region of the first conductivity type arranged on the body region,

Example 18. The transistor device of claim 17, wherein the contact is in electrical contact with the field plate, the source region and the body region.

Example 19. The transistor device of claim 17 or 18, wherein a doping concentration in the drift region increases along a direction pointing from the first major surface to a second major surface of the semiconductor substrate opposing the first major surface.

Example 20. The transistor device of any one of examples 2 to 19, wherein the contact and the field pate extend to the first major surface.

Example 21. The transistor device of any one of examples 1 to 20, wherein an upper surface of the field plate and an upper surface of the contact are substantially coplanar with the first major surface.

Example 22. The transistor device of any one of examples 1 to 21, wherein the field dielectric has a thickness that increases from the top towards the base of the columnar trench.

Example 23. The transistor device of any one of examples 1 to 22, wherein the columnar trenches each comprise a field dielectric that is arranged on the base and the side wall and that has a thickness t₁ in a first region of the side wall that is contiguous to the body region and a thickness t₂ in a second region of the side wall that is contiguous to the drift region, wherein t₁ ≤ 1.15 t₂ or t₁ ≤ 1.2 t₂ or t1 ≤ 1.5 t₂.

Example 24. The transistor device of any one of examples 1 to 23, wherein the side face of the field plate comprises a step such that an upper portion of the field plate has a width that is greater than a width of a lower portion of the field plate and such that the field dielectric has a thickness t₁ in a first region of the side wall of the columnar trench and a thickness t2 in a second region of the side wall of the columnar trench, wherein t₁ ≤ 1.15 t₂ or t₁ ≤ 1.2 t₂ or t1 ≤ 1.5 t₂.

Example 25. The transistor device of any one of examples 1 to 24, wherein the step is located at a depth d₁ from the first major surface of the semiconductor substrate and the pn junction formed between the body region and the drift region has a depth dₚₙ from the first major surface of the semiconductor substrate, wherein d₁ > dₚₙ.

Example 26. The transistor device of any one of examples 1 to 25, wherein a plurality of columnar trenches is provided and the columnar trenches are arranged in offset rows.

Example 27. The transistor device of any one of examples 1 to 26, Wherein the columnar trenches are substantially square or substantially hexagonal or substantially octagonal in top view.

Example 28. The transistor device of any one of examples 1 to 27, wherein the one or more transistor cells further comprises:
a gate trench formed in the mesa, wherein the gate trench comprises a base and a side wall,
a gate dielectric that lines the base and side wall of the gate trench, and
a gate electrode arranged in the gate trench, wherein the gate trench surrounds the columnar trench, or
further comprises:
   a planar gate electrode arranged on the mesa, wherein the planar gate electrode laterally surrounds the columnar trench

Example 29. The transistor device of example 28, wherein the gate electrode has grid structure that comprises a square or a hexagonal or octagonal grid structure in top view.

Example 30. The transistor device of any one of examples 1 to 29,wherein the field dielectric comprises a first layer and a second layer and wherein the first thickness of the field dielectric is substantially equal to a thickness of the first layer and the second thickness of the field dielectric is substantially equal to the sum of the thickness of the first layer and the thickness of the second layer.

Example 31. A method, comprising:
forming a plurality of columnar trenches in a first major surface of a semiconductor substrate having a first conductivity type, the columnar trenches each having a base and a side wall extending from the base to the first major surface;
forming a first dielectric layer on the base and side wall of the columnar trenches;
depositing a second dielectric layer on the first dielectric layer;
removing at least a part of the second dielectric layer from an upper portion of the columnar trenches; and
inserting conductive material into the columnar trenches to form a field plate.

Example 32. The method of example 31, wherein the forming a first dielectric layer on the base and side wall of the columnar trenches comprises thermally growing the first dielectric layer.

Example 34. The method of example 31 or example 32, wherein the depositing a second dielectric layer comprises depositing the second dielectric layer on the first dielectric layer using a TEOS process.

Example 35. The method of example 34, further comprising after depositing the second dielectric layer on the first dielectric layer using a TEOS process carrying out an annealing process to densify the second dielectric layer.

Example 36. The method of any one of examples 31 to 35, further comprising selectively removing the second dielectric layer from an upper portion of the trench and exposing the first dielectric layer.

Example 37. The method of any one of examples 31 to 36, further comprising after depositing the second dielectric layer on the first dielectric layer, inserting material into the columnar trenches.

Example 38. The method of claim 37, wherein the material is sacrificial material or conductive material.

Example 39. The method of example 37 or example 38, further comprising removing a portion of the material from an upper portion of the columnar trenches and exposing the second dielectric layer on the side wall of the upper portion of the columnar trenches.

Example 40. The method of any one of examples 37 to 39,
wherein the material is sacrificial material and the method further comprises after selectively removing the exposed second dielectric liner layer from the side wall of the upper portion of the columnar trenches, removing the material from a lower portion of the trench and exposing the second dielectric layer in a lower portion of the trench and then inserting conductive material into the columnar trenches and forming a field plate, or
wherein the material is conductive material and the method further comprises forming the conductive material on the first major surface when inserting conductive material into the columnar trenches, performing a planarisation process and forming a field plate in the columnar trenches.

Example 41. A method of fabricating a transistor device, the method comprising
performing the method according to any one of examples 31 to 40, wherein the semiconductor substrate has a first conductivity type,
implanting dopants of a second conductivity type that opposes the first conductivity type into the first major surface and forming a body region;
implanting dopants of the first conductivity type into the first major surface and forming a source region on the body region
forming a gate trench in the mesa, the gate trench comprising a gate electrode and a gate dielectric;

Example 42. The method of example 41, further comprising:
removing a portion of the first and second dielectric layers from the upper portion of the columnar trench and forming a ring-shaped opening, the ring-shaped opening exposing the perimeter of the field plate and the mesa;
inserting conductive material into the ring-shaped opening and forming a ring-shaped contact that is in electrical contact with the field plate and the mesa.

Example 43. The method of any one of examples 31 to 42 further comprising:
forming a dielectric layer on the first major surface,
forming a ring-shaped opening in the dielectric layer, the ring-shaped opening exposing the perimeter of the field plate and a contiguous region of the first major surface;
removing the first dielectric layer from the upper portion of the columnar trench and the dielectric layer from the exposed contiguous region of the semiconductor substrate and a peripheral region of the field plate and forming a ring-shaped opening;
inserting conductive material into the ring-shaped opening and forming a ring-shaped contact that is in electrical contact with the field plate, the body region and the source region.

Example 44. The method of any one of examples 31 to 43, further comprising implanting second dopants into the ring-shaped opening

Example 45. A method according to claim 44, further comprising selectively removing the material of the semiconductor substrate over the material of the first dielectric liner layer such that an upper section of the first dielectric liner layer protrudes from the base of the ring-shaped opening.

Example 46. The method of any one of examples 31 to 45, wherein forming the ring-shaped contact comprises forming one or more conductive layers in the ring-shaped opening and filling the ring-shaped opening with conductive material.

Example 47. The method of any one of examples 31 to 46, further comprising applying a conductive layer onto the ring-shaped contact that extends over the first major surface.

Spatially relative terms such as "under", "below", "lower", "over", "upper" and the like are used for ease of description to explain the positioning of one element relative to a second element. These terms are intended to encompass different orientations of the device in addition to different orientations than those depicted in the figures. Further, terms such as "first", "second", and the like, are also used to describe various elements, regions, sections, etc. and are also not intended to be limiting. Like terms refer to like elements throughout the description.

As used herein, the terms "having", "containing", "including", "comprising" and the like are open ended terms that indicate the presence of stated elements or features, but do not preclude additional elements or features. The articles "a", "an" and "the" are intended to include the plural as well as the singular, unless the context clearly indicates otherwise. It is to be understood that the features of the various embodiments described herein may be combined with each other, unless specifically noted otherwise.

Although specific embodiments have been illustrated and described herein, it will be appreciated by those of ordinary skill in the art that a variety of alternate and/or equivalent implementations may be substituted for the specific embodiments shown and described without departing from the scope of the present invention. This application is intended to cover any adaptations or variations of the specific embodiments discussed herein. Therefore, it is intended that this invention be limited only by the claims and the equivalents thereof.

## Claims

1. A transistor device, comprising:
a semiconductor substrate having a first major surface; and
one or more transistor cells, each transistor cell comprising:
a columnar trench formed in the semiconductor substrate, wherein the columnar trench comprises a field dielectric, a base and a side wall, wherein the side wall extends from the base to the first major surface and the field dielectric lines the base and side wall of the columnar trench, wherein a first thickness of the field dielectric at a first distance from the base is smaller than a second thickness of the field dielectric at a second distance from the base, wherein the first distance is greater than the second distance;
a columnar field plate arranged in the columnar trench, wherein a first perimeter of the columnar field plate at the first distance is greater than a second perimeter of the columnar field plate at the second distance; and
a mesa arranged around the columnar trench.

2. The transistor device of claim 1, further comprising a contact located at least partially within the columnar trench and forming an electrical contact between the field plate and the mesa.

3. The transistor device of claim 2, wherein a central region of the field plate remains uncovered by the contact.

4. The transistor device of any one of claims 1 to 3,
wherein a third perimeter of the columnar field plate at a third distance from the base is larger than the first perimeter, wherein the third distance is greater than the first distance.

5. The transistor device of any one of claims 2 to 4, wherein the contact has a width that is greater than the first thickness of the field dielectric.

6. The transistor device of any one of claims 1 to 5, wherein the mesa comprises a drift region of a first conductivity type, a body region of a second conductivity type that opposes the first conductivity type, the body region being arranged on the drift region, and a source region of the first conductivity type arranged on the body region,

7. The transistor device of claim 6, wherein the contact is in electrical contact with the field plate, the source region and the body region.

8. The transistor device of claim 6 or 7, wherein a doping concentration in the drift region and adjacent to the columnar trench increases along a direction pointing from the first major surface to a second major surface of the semiconductor substrate opposing the first major surface.

9. The transistor device according to any one of claims 1 to 8, wherein the side face of the field plate comprises a step such that an upper portion of the field plate has a width that is greater than a width of a lower portion of the field plate and such that the field dielectric has a first thickness t₁ in a first region of the side wall of the columnar trench and a second thickness t2 in a second region of the side wall of the columnar trench, wherein t₁ ≤ 1.15 t₂ or t₁ ≤ 1.2 t₂ or t1 ≤ 1.5 t₂.

10. The transistor device according to any one of claims 1 to 9, wherein the one or more columnar trenches are arranged in offset rows.

11. The transistor device of any of the preceding claims, wherein the one or more transistor cells further comprise:
a gate trench formed in the mesa, wherein the gate trench comprises a base and a side wall,
a gate dielectric that lines the base and side wall of the gate trench, and
a gate electrode arranged in the gate trench, wherein the gate trench surrounds the columnar trench,

12. The transistor device of any one of claims 1 to 10, wherein the one or more transistor cells further comprise:
a planar gate electrode arranged on the mesa, wherein the planar gate electrode laterally surrounds the columnar trench

13. The transistor device of any of the preceding claims,
wherein the field dielectric comprises a first layer and a second layer,
wherein the first thickness of the field dielectric is substantially equal to a thickness of the first layer, and wherein the second thickness of the field dielectric is substantially equal to the sum of the thickness of the first layer and the thickness of the second layer.

14. A method, comprising:
forming a plurality of columnar trenches in a first major surface of a semiconductor substrate having a first conductivity type, the columnar trenches each having a base and a side wall extending from the base to the first major surface;
forming a first dielectric layer on the base and side wall of the columnar trenches;
depositing a second dielectric layer on the first dielectric layer;
removing at least a part of the second dielectric layer from an upper portion of the columnar trenches; and
inserting conductive material into the columnar trenches to form a field plate.

15. A method of fabricating a transistor device, the method comprising
performing the method according to claim 14, wherein the semiconductor substrate has a first conductivity type,
implanting dopants of a second conductivity type that opposes the first conductivity type into the first major surface and forming a body region;
implanting dopants of the first conductivity type into the first major surface and forming a source region on the body region
forming a gate trench in the mesa, the gate trench comprising a gate electrode and a gate dielectric;

16. The method of claim 15, further comprising:
removing a portion of the first and second dielectric layers from the upper portion of the columnar trench and forming a ring-shaped opening, the ring-shaped opening exposing the perimeter of the field plate and the mesa;
inserting conductive material into the ring-shaped opening and forming a ring-shaped contact that is in electrical contact with the field plate and the mesa.

17. A method according to claim 16, further comprising selectively removing the material of the semiconductor substrate over the material of the first dielectric liner layer such that an upper section of the first dielectric liner layer protrudes from the base of the ring-shaped opening.
